# EUROPEAN PATENT APPLICATION

(11) **EP 1 684 419 A1**
(43) Date of publication of application: **26.07.2006**
(21) Application number: 05078001.4
(22) Date of filing: 27.12.2005
(51) Int. Cl.: H03G 3/34, H03G 3/32

(54) **In-vehicle entertainment system**

(30) Priority: 13.01.2005 US 35211
(71) Applicant: Delphi Technologies, Inc., Troy, MI 48007 (US)
(72) Inventor: Deetz, Kenneth L., Warren, IN 46792 (US); Torke, Richard A., Westfiled, IN 46074 (US)
(74) Representative: Denton, Michael John

(57) **Abstract**

An in-vehicle entertainment system comprising an entertainment device configured to broadcast an audio signal, at least one set of headphones configured to receive the audio signal; and at least one microphone coupled to said entertainment device, wherein the entertainment device is configured to selectively attenuate the audio signal and to broadcast a mixed audio signal to the headphones when the microphone is activated.

## Description

### TECHNICAL FIELD

The present invention generally relates to an apparatus for communicating, and in particular, to an apparatus for communicating amongst individual passengers within a vehicle.

### BACKGROUND OF THE INVENTION

The automotive industry is increasingly focusing on improvements within the interior of the vehicle. Innovations in technology and design have increased passenger comfort and satisfaction. One recent innovation, particularly in larger vehicles such as minivans and sports utility vehicles, is the in-vehicle entertainment system. Such systems may include one or more electronic components. A few examples of in-vehicle entertainment systems include televisions, stereos, digital versatile disc players, video game consoles, and computers.

In-vehicle entertainment systems provide a variety of entertainment options. For example, passengers may use the in-vehicle entertainment system to watch television or recorded videos, listen to music or play video games. The in-vehicle entertainment system is particularly useful in providing children with activities during long trips.

However, the in-vehicle entertainment systems may interfere with communication amongst passengers. For instance, if the in-vehicle system is playing loudly, it may cause difficulty in communication between passengers sitting in the front and passengers sitting in the back. The communication problem is compounded by the fact that the passengers in the front seats are facing forward with their backs to the passengers in the rear seats, and thus their voices project towards the windshield. Communication is even more difficult for the driver, who cannot safely turn around to communicate with passengers in the rear seats.

### SUMMARY OF THE INVENTION

An in-vehicle entertainment system comprising an entertainment device configured to broadcast an audio signal, at least one set of headphones configured to receive the audio signal; and at least one microphone coupled to said entertainment device, wherein the entertainment device is configured to selectively attenuate the audio signal and to broadcast a mixed audio signal to the headphones when the microphone is activated.

### BRIEF DESCRIPTION OF THE DRAWINGS

Figure 1 is a perspective view of a vehicle, including an in-vehicle entertainment system, according to an exemplary embodiment.
Figure 2 is a pictorial view of the in-vehicle entertainment system according to an exemplary embodiment.
Figure 3 is a schematic diagram of the in-vehicle entertainment system according to an exemplary embodiment.

### DESCRIPTION OF THE PREFERRED EMBODIMENTS

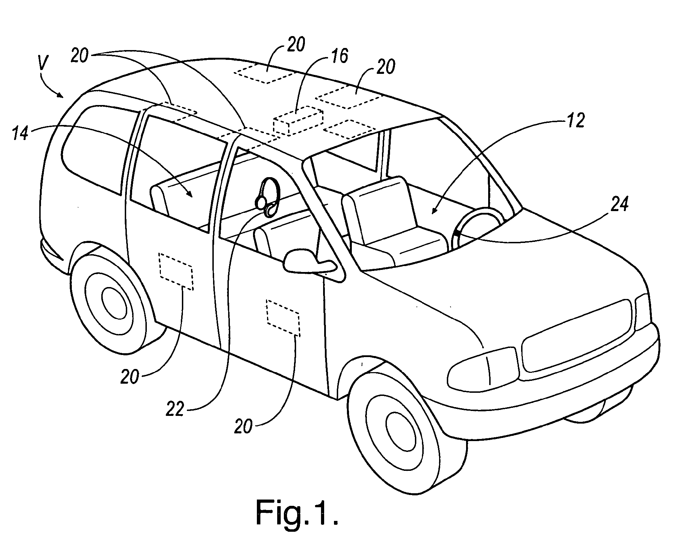

Figure 1 is a perspective view of a vehicle *V*, including an in-vehicle entertainment system 10, according to an exemplary embodiment of the present invention. The vehicle *V* includes a front, or driver compartment 12 and a rear, or passenger compartment 14. As illustrated, vehicle *V* is a sports utility vehicle. However, it can be appreciated that vehicle *V* may be a car, a truck, a van or any other type of vehicle.

The in-vehicle entertainment system 10 is configured for providing entertainment to passengers in the vehicle *V*. The in-vehicle entertainment system 10 includes an entertainment device 16, such as, for example, a digital versatile disc (DVD) player, a television, or a video game console. It can be appreciated that the in-vehicle entertainment system 10 may include any entertainment device 16 that may be adapted for use in the vehicle *V*. The various entertainment devices 16 may operate simultaneously to allow different passengers to use the different entertainment devices 16. For instance, front passengers may listen to a compact disc, while the back passengers may play a video game.

The in-vehicle entertainment system 10 may be operated using any number of control interfaces 18 known in the art. The control interface 18 is configured to activate a number of functions, such as, for example, playing, rewinding, forwarding, pausing and stopping the in-vehicle entertainment system 10. The vehicle *V* may include one control interface 18 located in the front compartment 12, as illustrated in Figure 1. Alternatively, the vehicle *V* may include a plurality of control interfaces 18 located within the vehicle *V*. For instance, the vehicle *V* may include one control interface 18 in the front compartment for use by passengers in the front and a control interface 18 in the rear compartment 14 for passengers in the back. In larger vehicles, such as full size vans with two or three rows of rear seats, a third control interface 18 may be located in the third row for passengers.

The in-vehicle entertainment system 10 includes at least one speaker 20 mounted within the passenger compartment 14 of the vehicle *V*. As illustrated in Figure 1, a plurality of speakers 20 are distributed throughout the front and passenger compartments 12, 14 of the vehicle *V*. The speakers 20 are configured for receiving electrical signals carrying audio information and converting the electrical signals to audible sounds. The speakers 20 may deliver identical audible sounds, or alternatively deliver different audible sounds. Different audible sounds may be delivered over the speakers 20 if different entertainment devices 16 are being used in the vehicle *V*.

The in-vehicle entertainment system 10 further includes at least one set of headphones 22 configured for receiving the electrical signals carrying audio information delivered from the entertainment device 16 and converting the electrical signals to audible sound. The headphones 22 may be either wired or wireless. As illustrated, the headphones 22 include two speaker pads designed to fit over the ears of a passenger. Alternatively, the headphones 22 may include two speakers designed to fit within the ears of the passengers. As with speakers 20, the headphones 22 may deliver identical audible sounds, or alternatively deliver different audible sounds. Different audible sounds may be delivered over the headphones 22 if different entertainment devices 16 are being used in the vehicle *V*. The headphones 22 allow passengers to listen to audible sounds without disturbing other passengers.

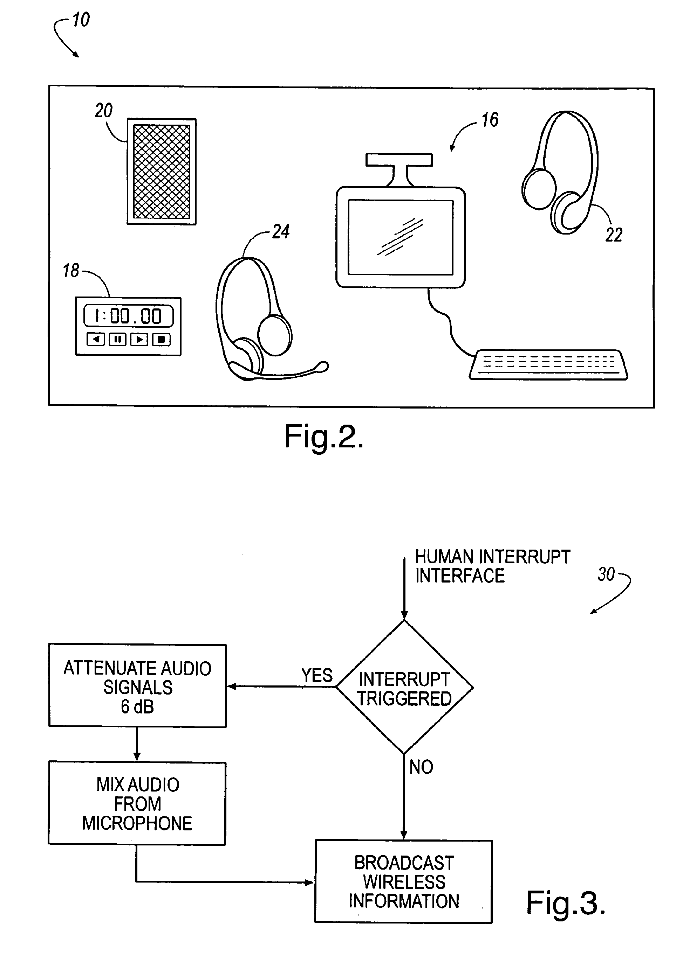

The in-vehicle entertainment system also includes at least one microphone 24. The microphone 24 may be integrated into the vehicle *V*, as illustrated in Figure 1, may be integrated into a headset, as illustrated in Figure 2, or may be a handheld microphone (not shown). In an exemplary embodiment, the microphone 24 may be an Onstar™ microphone currently available in most General Motors Corporation vehicles. It can be appreciated that multiple microphones 24 may be included in the vehicle *V* for use by the passengers in the front and rear compartments 12, 14.

The microphone 24 may be wired, or wirelessly connected, to speakers 20 and headphones 22. In an exemplary embodiment, microphone 24 is wired to speakers 20 and wirelessly connected to headphones 22. The microphone 24 may be wired to speakers 20 by integrating the microphone 24 in the vehicle *V*, such as in the steering wheel or control interface, and including wires for transmitting electrical signals to the speakers 20. The microphone 24 and speakers 20 form a traditional intercom system.

The microphone may be wirelessly connected to the headphones 22 by an antenna, or any other type of transmitter known in the art. It should be noted that the speaker 20, headphones 22 and microphone 24 may wirelessly deliver audible sounds using wireless communication technology known in the art, such as, for example, using radio frequency, microwave, infrared, or any other type of signal used in wireless communication.

The microphone 24 allows for communication amongst passengers in the vehicle *V*. The microphone 24 may be activated by manually depressing a button (not shown) or triggering a switch (not shown). Alternatively, microphone 24 may be activated by use of a voice recognition interface (not shown), such that the passenger may activate the microphone 24 by simply speaking, or otherwise inputting sound, into the microphone 24. It can be appreciated that headphones 22 may also include a microphone 24, so that passengers wearing the headphones 22 may also deliver messages to other passengers, including passengers in the front compartment 12.

Activating the microphone 24 in turn activates an attenuation circuit 30, to automatically attenuate, or lower the level of audible sounds, currently being delivered over speakers 20 and headphones 22 by the entertainment device 16. In an alternate embodiment, the attenuation circuit 30 may interrupt, or stop, the audible sounds being delivered over speakers 20 and headphones 22 by the entertainment device 16. Additionally, activating microphone 24 may concurrently suspend the performance of entertainment device 16. For example, in the case of a passenger playing a video game, the audible sound from the video game may be suspended, as well as the video signal from the video game. Following deactivation of the microphone 24, the audible sound from the entertainment device 16 will return to the original level of volume.

Once the microphone 24 is activated, the message is transmitted from the microphone 24 to either the speakers 20, headphones 22 or both. If the message is delivered over the speakers 20, the message may be delivered with sufficient volume to be audible to passengers still wearing headphones 22 and over other extraneous noises in the vehicle *V*. Delivering the message over the speakers 20 allows the passenger using the microphone 24 to deliver the message to all passengers.

In the exemplary embodiment of the invention, the microphone 24 may deliver the message to only the headphones 22. The message from the microphone 24 may be transmitted to the headphones 22 at the same volume level of the attenuated audible sound from the entertainment device 16. Alternatively, the volume level of the message from the microphone 24 may be adjusted to be either higher or lower than the attenuated audible sound from the entertainment device 16.

Delivering the message from the microphone 24 to those passengers using the headphones 22 advantageously allows for intimate communication between some of the passengers. For example, if some passengers in the vehicle are sleeping and other passengers are using the entertainment device 16 and headphones 22, delivering message through the headphones 22 will allow passengers to communicate without disturbing those who are sleeping.

Figure 3 is a schematic diagram of the attenuate circuit 30 according to an exemplary embodiment. The attenuate circuit 30 detects the input of a signal. The signal may be either a manual signal, such as triggering a switch or detecting an audible sound, such as the beginning of a message. If the attenuate circuit 30 is detected, the audible sound from the entertainment device 16 may be reduced, or alternatively, muted. Then the message from the microphone 24 is mixed with the audible sound from the entertainment device 16 and delivered through the headphones 22. It can be appreciated that the volume in which the message is deliver to the headphones 22 from the microphone 24 may be increased, decreased or delivered at the same volume in which the audible sound from the entertainment device 16 was delivered.

The embodiments disclosed herein have been discussed for the purpose of familiarizing the reader with novel aspects of the invention. Although preferred embodiments of the invention have been shown and described, many changes, modifications and substitutions may be made by one having ordinary skill in the art without necessarily departing from the spirit and scope of the invention as described in the following claims.

## Claims

1. An in-vehicle entertainment system comprising:
an entertainment device configured to broadcast an audio signal;
at least one set of headphones configured to receive the audio signal; and
at least one microphone coupled to said entertainment device, wherein the entertainment device is configured to selectively attenuate the audio signal and to broadcast a mixed audio signal to the headphones when the microphone is activated.

2. The in-vehicle entertainment system as in claim 1, wherein the entertainment device selectively attenuates the audio signal being broadcasted when the microphone is activated by an input signal.

3. The in-vehicle entertainment system as in claim 1, wherein the entertainment device selectively attenuates the audio signal being broadcasted when the microphone is activated by a voice signal.

4. The in-vehicle entertainment system as in claim 1, wherein attenuating the audio signal comprises muting the audio signal broadcast by the entertainment device.

5. The in-vehicle entertainment system as in claim 1, wherein attenuating the audio signal comprises reducing the volume of the audio signal broadcast by the entertainment device.

6. The in-vehicle entertainment system as in claim 1, wherein the entertainment device is configured to broadcast a video signal.

7. The in-vehicle entertainment system as in claim 6, wherein the entertainment device is configured to selectively attenuate the video signal and to broadcast a mixed audio signal to the headphones when the microphone is activated.

8. The in-vehicle entertainment system as in claim 1, further comprising at least one speaker configured to receive an electrical signal from the entertainment device and deliver the audio signal, and wherein the entertainment device is configured to selectively attenuate the audio signal delivered by the speaker and to deliver a mixed audio signal to the speaker when the microphone is activated.

9. A method of communicating with passengers in a vehicle, the method comprising the steps of:
broadcasting an audio signal from an entertainment device to at least one set of headphones;
activating a microphone by an input signal,
attenuating the broadcast of the audio signal by activation of the microphone, and
transmitting a mixed audio signal from the microphone to the at least one set of headphones.

10. The method of claim 9, wherein the input signal consists of depressing a button.

11. The method of claim 9, wherein the input signal consists of a voice signal.

12. The method of claim 9, wherein attenuating the broadcast comprises interruption of the audio signal.

13. The method of claim 9, further including the step of broadcasting a video signal from the entertainment device.

14. The method of claim 13, wherein attenuating the broadcast comprising muting the audio signal and simultaneously halting the video signal.

15. A system for interfacing with passengers in a vehicle comprising:
an in-vehicle entertainment system including an entertainment device configured to generate a video and an audio signal and a set of headphones configured to receive and deliver the audio signal to a passenger; and
a microphone including an attenuation circuit,
wherein the attenuation circuit is configured to attenuate the video and the audio signal.
